# FASCICULE DE BREVET EUROPEEN

(11) **EP 2 559 080 B1**
(45) Date de publication et mention de la délivrance du brevet: **20.05.2020**
(21) Numéro de dépôt: 11717764.2
(22) Date de dépôt: 01.04.2011
(51) Int. Cl.: H01L 51/52, H01L 51/56

(54) **DISPOSITIF OPTOELECTRONIQUE ORGANIQUE ET SON PROCEDE D'ENCAPSULATION**
ORGANISCHES OPTOELEKTRONISCHES BAUELEMENT UND VERKAPSELUNGSVERFAHREN DAFÜR
ORGANIC OPTOELECTRONIC DEVICE AND METHOD FOR ENCAPSULATING SAME

(30) Priorité: 12.04.2010 FR 1001522
(43) Date de publication de la demande: 20.02.2013
(73) Titulaire: Commissariat à l'Énergie Atomique et aux Énergies Alternatives, 75015 Paris (FR)
(72) Inventeur: MAINDRON, Tony, 38000 Grenoble (FR); AVENTURIER, Bernard, 38134 Saint Joseph De Riviere (FR); DE GIROLAMO, Julia, 38190 Lancey (FR)
(74) Mandataire: Gevers & Orès
(86) Numéro de dépôt international: PCT/IB2011/051412
(87) Numéro de publication internationale: WO 2011/128802

(56) Documents cités:
- EP-A2- 1 986 248
- DE-A1-102006 015 043
- FR-A1- 2 936 651
- JP-A- 2007 080 569
- US-A1- 2003 209 708
- US-A1- 2006 087 230

## Description

La présente invention concerne un dispositif optoélectronique organique, tel qu'un dispositif d'affichage, d'éclairage ou de signalisation, qui est protégé de l'air ambiant par une encapsulation étanche de type incluant des couches minces, et un procédé d'encapsulation d'un tel dispositif. L'invention s'applique notamment à des dispositifs à diodes électroluminescentes organiques (« OLED ») tels que des microécrans.

De manière connue, les dispositifs optoélectroniques organiques, tels que les « OLED », les dispositifs à cellules photovoltaïques et ceux à « TFT » organiques nécessitent d'être encapsulés, pour assurer la protection de leurs composants sensibles contre les espèces gazeuses de l'atmosphère (principalement l'oxygène et la vapeur d'eau). En effet, si cette protection n'est pas convenablement réalisée, il risque de se produire une dégradation ultérieure du dispositif qui se manifeste principalement par l'apparition de points noirs non émissifs dans le cas des « OLED », qui sont en fait la résultante de la pénétration de la vapeur d'eau dans la diode, ce qui dégrade l'interface cathode (ou anode) / film(s) organique(s).

Cette encapsulation peut être typiquement réalisée grâce à l'utilisation d'un capot de verre collé sur le dispositif organique à l'aide d'une colle spécifique présentant notamment une faible perméabilité à l'eau. En général, on ajoute un absorbeur d'humidité solide ou « getter » entre le substrat et le capot pour prolonger la durée de vie du dispositif.

Pour certaines applications mais aussi pour une question de réduction de coût, on a développé des couches minces à effet de barrière dont le rôle, par similitude à cet ensemble capot-getter, est de protéger le dispositif sous-jacent de l'agression de l'humidité. D'une manière générale, ces couches barrières sont des oxydes, des nitrures ou des oxynitrures ou, dans certains cas, il peut s'agir de couches minces métalliques sauf si l'unité électroluminescente émet par le sommet de la structure (« top émission » en anglais) auquel cas les couches barrières doivent être transparentes.

Ces couches minces sont déposées par des procédés standards de dépôt sous vide tels que le dépôt chimique en phase vapeur (« CVD ») éventuellement assisté par plasma (« PECVD »), le dépôt de couche atomique (« ALD », parfois appelée « AL-CVD ») ou par des procédés de dépôt physique en phase vapeur (« PVD ») incluant l'évaporation et la pulvérisation. Pour l'effet de barrière, on privilégie notamment les technologies « CVD » et en particulier « ALD » qui, à basse température donnent des couches barrières denses, avec peu de défauts (« pinholes » en anglais pour trous d'aiguilles) et 100 % conformes à des températures le plus souvent inférieures à 110° C qui sont compatibles avec les « OLED ». A basse température, il a ainsi été montré une densité de défauts d'une couche Al₂O₃ déposée par « ALD » aussi faible que 38/cm². Pour des applications de microécrans, cette densité de défauts est néanmoins trop élevée car si l'on considère une surface de microécran de 45 mm², cela conduit à 17 défauts par microécran soit potentiellement 17 points noirs sur l'afficheur « OLED ». En effet, même si ces points noirs intrinsèques à la fabrication sont microscopiques, leur présence est prohibée sur un dispositif « OLED » dont l'image est magnifiée par une optique adaptée, et il faut en outre leur ajouter les points noirs « extrinsèques » dus à la présence de particules indésirables à la surface du dispositif lors de l'encapsulation en couches minces.

Par ailleurs, on sait qu'il faut protéger de l'eau sur le long terme l'Al₂O₃ déposé par « ALD » car il a tendance à s'hydrolyser en Al(OH)ₓ. On a donc cherché à passiver de manière pérenne cette barrière que constitue un tel film d'Al₂O₃ par des matériaux inorganiques plus inertes chimiquement et plus stables tels que SiO₂, Si₃N₄ ou SiOₓN_{y}, via des dépôts mis en œuvre par « PECVD » à basse température qui permettent également de boucher les défauts résiduels de ces films d'Al₂O₃.

En variante, on a cherché à passiver ces films d'Al₂O₃ déposés par « ALD » par des couches organiques relativement épaisses à base de polymères « planarisants » censés remédier à l'inconvénient des particules indésirables précitées en les enrobant à la manière d'un empilement Barix™ de la société Vitex, avec un empilement de couches organiques et inorganiques alternées. Un inconvénient de cette solution réside dans le procédé en phase gazeuse de type évaporation « flash » (i.e. évaporation du monomère, condensation sur substrat puis insolation UV pour la réticulation) qui est relativement coûteux en temps.

Il est difficile d'envisager d'autres types de dépôt moins coûteux en temps comme le dépôt en phase liquide, car ce type de dépôt nécessite l'utilisation de solutions polymériques contenant des solvants susceptibles de dissoudre les couches de l'unité électroluminescente sous-jacente.

Le document DE 102006 015043 A1 présente un dispositif d'affichage électronique. Cependant, dans ce document la structure d'encapsulation ne comprend pas d'empilement interne composé d'un film inorganique recouvrant la zone active, lui-même recouvert d'une couche polymérique photosensible. D'autre part, la couche organique ne présente pas de portion enveloppante structurée.

Le document US 2003/209708 A1 porte sur un dispositif optoélectronique organique présentant une zone active d'émission lumineuse revêtue d'une structure multicouche d'encapsulation étanche, la structure d'encapsulation comprenant un ou plusieurs empilements de film inorganique/couche polymérique photosensible incluant un empilement interne qui recouvre la zone active. Cependant, le procédé de fabrication est complexe et les contraintes structurelles ne permettent pas de réaliser des étapes de photogravure.

Un but de la présente invention est de proposer un dispositif optoélectronique organique, tel qu'un dispositif « OLED » d'affichage, d'éclairage ou de signalisation, qui permette de remédier aux inconvénients précités en proposant une protection fiable et pérenne de l'unité électroluminescente à moindre coût, ce dispositif étant défini par l'objet de la revendication 1.

Comme cela sera détaillé ci-après, cette structure gravée totalement enrobante de la ou de chaque couche photosensible vis-à-vis de la ou de chaque zone active de l'unité électroluminescente (i.e. une structure non seulement enrobante pour la face externe de cette zone active mais encore pour ses faces latérales) peut être précisément obtenue grâce à la photolithographie c'est-à-dire par insolation locale de la couche photosensible au moyen d'un masque et d'un développement de cette couche, cette gravure permettant de structurer et donc de localiser précisément ladite au moins une portion enveloppante de chaque zone active par rapport à la zone de connexion électrique adjacente devant être laissée libre et également par rapport aux portions enveloppantes des zones actives adjacentes.

Avantageusement, la ou chaque couche photosensible C1, ..., Cn peut être à base d'une résine positive de photolithographie. Par « résine positive », on entend de manière connue une résine qui se polymérise lors de son dépôt, les parties insolées au rayonnement UV sélectivement à travers un masque étant dépolymérisées puis dissoutes lors du développement. En variante, cette résine peut être négative (i.e. par définition sa zone insolée se polymérisant et devenant ainsi insoluble lors du développement).

Selon une autre caractéristique de l'invention, le ou chaque film F1, ..., est déposé sur la ou chaque zone active par dépôt de couche atomique (« ALD ») ou bien par dépôt chimique en phase vapeur assisté par plasma (« PECVD »), et est à base d'au moins un composé inorganique choisi dans le groupe constitué par les composés de formule AlₓO_{y}, SiOₓ, SiₓN_{y}, SiOₓN_{y}, ZnSe, Sb₂O₃ et les oxydes transparents conducteurs (OTC) optionnellement combinés à un métal, tel que l'aluminium.

Selon un premier mode de réalisation de l'invention, le ou chaque film F1, ..., Fn est déposé par « ALD » et est à base d'au moins un oxyde d'aluminium AlₓO_{y} optionnellement combiné à un composé de formule SiOₓ, SiₓN_{y} ou SiOₓN_{y}, et ladite au moins une portion enveloppante de la ou couche C1, ..., Cn peut s'étendre alors sur l'unité électroluminescente au-delà de la périphérie de ce film.

Selon un second mode de réalisation de l'invention, le ou chaque film F1, ..., Fn est déposé par « ALD » et est à base d'au moins un oxyde transparent conducteur (OTC) optionnellement combiné à un métal, tel qu'un oxyde de zinc de formule ZnO ou une couche mince ZnO:Al, et ladite au moins une portion enveloppante de la ou couche C1, ..., Cn peut s'étendre alors au contact de la périphérie de ce film.

On notera qu'en référence tant à ce premier qu'à ce second modes, le dépôt par voie humide de la ou chaque couche photosensible C1, ..., Cn est réalisable grâce aux excellentes qualités passivantes du film F1, ..., Fn avantageusement à base d'oxyde d'aluminium ou d'oxyde de zinc qui sert de pré-encapsulation. La ou chaque couche C1, ..., Cn isolant la ou chaque zone active est elle-même recouverte d'un film inorganique externe diélectrique à effet de barrière qui surmonte à la fois la ou chaque zone active en recouvrant la totalité de sa ou de sa dernière couche C1, ..., Cn correspondante et sa zone de connexion adjacente, de sorte à isoler de l'extérieur ladite au moins une portion enveloppante de cette couche.

Selon un autre aspect de l'invention, ledit dispositif peut être en outre pourvu d'une plaque de protection (réalisable en un matériau transparent à la lumière émise par l'unité électroluminescente, comme le verre ou une matière plastique) qui est collée sous pression sur la structure d'encapsulation surmontant la ou chaque zone active au moyen d'une colle, et ladite portion enveloppante relative à la ou chaque zone active présente des entailles lui conférant par exemple une forme régulièrement crénelée, de sorte à maximiser le contact entre la colle et les emplacements de l'unité électroluminescente situés entre deux portions enveloppantes adjacentes sans pénaliser l'adhésion de ces dernières sur cette unité.

Selon une variante de réalisation de l'invention, la ou chaque couche C1, ..., Cn peut être gravée de sorte que ladite au moins une portion enveloppante qu'elle présente comprenne une portion périphérique débordante qui déborde de manière continue au-delà dudit bord de la ou de chaque zone active en enrobant cette dernière, et au moins une portion périphérique enveloppante auxiliaire qui entoure de manière espacée cette portion débordante et qui, dans le cas de plusieurs portions auxiliaires, s'entourent mutuellement, et ledit film externe diélectrique à effet de barrière recouvre ces portions auxiliaires de sorte à former une pluralité de surfaces parallèles entre elles et perpendiculaires au plan du substrat qui forment autant d'obstacles à la pénétration latérale de vapeur d'eau vers cette zone active.

Selon une autre caractéristique de l'invention, ledit dispositif optoélectronique peut comprendre une multitude de zones actives, telles que des microécrans, qui sont toutes surmontées par les films F1, ..., Fn et par les couches C1, ..., Cn qui s'étendent chacune au-delà dudit bord sous-jacent mais à distance de ladite portion enveloppante adjacente de chaque zone active voisine, un film inorganique externe diélectrique surmontant optionnellement les couches ou dernières couches respectives des zones actives en recouvrant également leurs zones de connexion adjacentes.

Avantageusement, ce dispositif peut former au moins un microécran couleur qui est défini par la ou chaque zone active et qui comporte des filtres colorés ou des moyens changeurs de couleurs en regard de points de couleur correspondants de chaque pixel du microécran.

Encore plus avantageusement, ce dispositif peut comprendre un substrat revêtu sur l'une au moins de ses faces de l'unité électroluminescente de type « OLED » qui comporte au moins deux électrodes interne et externe entre lesquelles est intercalée une structure émettrice de lumière et dont l'une au moins est transparente à la lumière émise, et la structure d'encapsulation peut alors recouvrir l'électrode externe.

Un procédé d'encapsulation selon l'invention d'un dispositif tel que défini ci-dessus est défini par l'objet de la revendication 10.

On notera que l'étape a) est mise en œuvre par « ALD », dépôt réalisable à basse température et permettant d'obtenir un film de densité élevée et de perméabilité très réduite qui épouse au plus près les micro- ou nanoreliefs de la surface sous-jacente.

On notera également que ce film déposé par « ALD » permet l'usage de solvants polaires ou apolaires, e.g. l'éthanol, l'eau, acétone et de solutions de développement/stripping de résines photosensibles tels que celles de dénominations TMAH et ROR.

Quant à l'étape b), elle peut être mise en œuvre par toute technique d'enduction comme par exemple à la tournette ou via un revêtement par immersion ou « dip-coating ».

De préférence, on utilise à titre de polymère photosensible pour la couche C1, ..., Cn une résine positive de photolithographie et, à l'étape c), l'on masque sélectivement la ou chaque couche photosensible surmontant la ou chaque zone active au moyen d'un masque débordant en regard dudit bord périphérique pour que cette couche y soit protégée de l'insolation en demeurant polymérisée y compris en ladite au moins une portion enveloppante correspondante, au contraire du reste de cette couche qui est dépolymérisée par cette insolation en vue de sa dissolution.

Conformément au premier mode précité de réalisation de l'invention, l'on utilise pour le ou chaque film F1, ..., Fn à déposer à l'étape a) au moins un composé inorganique diélectrique choisi dans le groupe constitué par les composés de formule AlₓO_{y}, SiOₓ, SiₓN_{y}, SiOₓN_{y}, ZnSe et Sb₂O₃ et, suite à l'étape d), ladite au moins une portion enveloppante de la ou de chaque couche C1, ..., Cn s'étend sur l'unité électroluminescente au-delà de la périphérie de ce film.

Conformément au second mode précité de réalisation de l'invention, l'on utilise pour le ou chaque film F1, ..., Fn à déposer à l'étape a) au moins un oxyde transparent conducteur (OTC) optionnellement combiné à un métal, tel qu'un oxyde de zinc de formule ZnO ou une couche mince ZnO:AI et, suite à l'étape d), on réalise une gravure humide de ce film en utilisant à titre de masque la couche C1, ..., Cn polymérisée surmontant la ou chaque zone active de manière débordante, de sorte que ladite au moins une portion enveloppante de cette couche s'étende au contact de la périphérie de ce film et que ce dernier soit enlevé de l'unité partout ailleurs.

Selon une autre caractéristique de l'invention, l'on peut mettre en œuvre suite à l'étape d) une gravure sèche par exemple par gravure ionique réactive (« RIE ») ou par un plasma d'oxygène, de la ou de chaque couche C1, ..., Cn polymérisée pour réduire son épaisseur et donc satisfaire aux spécifications des microécrans concernant le problème des perturbations entre pixels (« cross-talk » en anglais).

Selon une autre caractéristique de l'invention, on met en œuvre suite à l'étape d) et éventuellement suite à cette gravure sèche un dépôt conformant à basse température d'un film inorganique externe à effet de barrière qui surmonte à la fois la ou chaque zone active en recouvrant la totalité de la couche C1, ..., Cn correspondante et sa zone de connexion adjacente, de sorte à isoler de l'extérieur ladite au moins une portion enveloppante de cette couche, ce dépôt conformant étant de préférence réalisé par un dépôt de couche atomique (« ALD ») ou un dépôt chimique en phase vapeur assisté par plasma (« PECVD ») d'au moins un composé diélectrique.

On notera que la structure d'encapsulation ainsi obtenue constitue une encapsulation monolithique robuste et que, dans le cas spécifique où l'épaisseur de l'empilement barrière revêt une importance particulière (cas des microécrans notamment où l'empilement doit être suffisamment fin afin d'éviter le « cross-talk » entre pixels), l'amincissement de la couche C1, ..., Cn par la gravure sèche précitée permet de parfaitement contrôler l'intervalle, au moins dans l'empilement barrière, entre chaque pixel du microécran et le filtre coloré correspondant.

D'autres avantages, caractéristiques et détails de l'invention ressortiront du complément de description qui va suivre en référence aux dessins annexés, donnés uniquement à titre d'exemples et dans lesquels :
la figure 1 est une vue schématique en coupe transversale d'un dispositif à microécran(s) selon le premier mode de l'invention en cours de fabrication, suite à l'étape b) d'enduction de l'unité électroluminescente par la couche à résine positive C1 recouvrant notamment un film diélectrique F1,
la figure 2 est une vue schématique en coupe transversale du dispositif de la figure 1 montrant l'étape c) d'insolation de cette couche C1,
la figure 3 est une vue schématique en coupe transversale du dispositif de la figure 2 suite à l'étape d) de développement de la couche C1,
la figure 4 est une vue schématique en coupe transversale du dispositif de la figure 3 montrant une étape ultérieure de gravure sèche mise en oeuvre sur la couche C1 insolée et développée,
la figure 5 est une vue schématique en coupe transversale du dispositif de la figure 4 montrant le résultat d'une étape de dépôt d'un film barrière inorganique sur la couche C1 suite à cette étape de gravure sèche,
la figure 6 est une vue schématique en coupe transversale du dispositif de la figure 4 en fin de fabrication selon ce premier mode de l'invention, suite à une étape finale de collage d'un capot transparent de protection muni de filtres colorés sur le dispositif de la figure 5,
la figure 7 est une vue schématique partielle de dessus de deux champs d'un dispositif à quatre microécrans où est représentée pour l'un deux la portion enveloppante d'une couche photosensible gravée C1 selon un exemple de l'invention en relation avec les microécrans voisins,
la figure 8 est une vue schématique de dessus d'un microécran d'un dispositif selon l'exemple de l'invention visible à la figure 7, montrant un exemple de recouvrement débordant de la couche photosensible gravée vis-à-vis de la zone active de ce microécran,
la figure 9 est une vue schématique partielle de dessus d'un microécran d'un dispositif selon une variante de l'invention par rapport à la figure 8, montrant un recouvrement avec portion enveloppante crénelée de la couche photosensible gravée vis-à-vis de la zone active de ce microécran,
la figure 10 est une vue schématique en coupe transversale d'un dispositif à microécran(s) selon le second mode de l'invention en cours de fabrication, suite à l'étape d) de développement d'une couche insolée à résine positive C1 recouvrant un film conducteur F1' déposé sur toute l'unité,
la figure 11 est une vue schématique en coupe transversale du dispositif de la figure 10 suite à une étape ultérieure de gravure humide de ce film F1' pour sa suppression sélective au-delà de la couche C1,
la figure 12 est une vue schématique en coupe transversale du dispositif de la figure 11 suite à une étape de dépôt d'un film barrière inorganique sur cette couche C1 faisant suite à cette gravure humide,
la figure 13 est un graphique relatif aux propriétés optiques du film inorganique conducteur F1' selon ce second mode de l'invention, montrant deux courbes respectivement de constantes optiques n et k en fonction de la longueur d'onde émise,
la figure 14 est une vue schématique de dessus d'un microécran d'un dispositif selon un autre exemple de l'invention, montrant pour la couche photosensible C1 recouvrant ce microécran surmonté d'un film inorganique F1, deux portions enveloppantes auxiliaires espacées autour d'une portion enveloppante débordant continûment de la zone active, et
la figure 15 est une vue schématique en coupe transversale du microécran de la figure 14 montrant en outre un capot transparent de protection collé sur un film barrière inorganique externe surmontant cette même couche C1.

La structure d'encapsulation multicouches 1, 101, 201 illustrée sur ces figures recouvre par exemple la face d'émission externe d'un dispositif optoélectronique électroluminescent 2, dont les composants sensibles sont à protéger de l'humidité et de l'oxygène de l'air ambiant.

Le dispositif optoélectronique 2 illustré est par exemple de type microécran « OLED », comprenant de manière connue un substrat 3 typiquement en silicium revêtu d'une unité électroluminescente 4 définissant une zone active 5 et une zone de connexion électrique 6. L'unité électroluminescente 4 comporte deux électrodes interne et externe (non visibles) entre lesquelles est intercalée une structure émettrice de lumière (non illustrée), l'une au moins des électrodes (dans cet exemple l'électrode externe telle que la cathode) étant transparente ou semi-transparente à la lumière émise afin de la faire rayonner via la zone active 5 vers l'extérieur du dispositif 2.

L'électrode externe est de préférence constituée d'un métal tel que l'argent, l'aluminium ou le samarium pour les propriétés de transparence de ces métaux dans le domaine visible ainsi que pour leur conductivité électrique à faible épaisseur (l'épaisseur de l'électrode externe est par exemple comprise entre 10 nm et 30 nm). Une couche supplémentaire, communément appelée « capping layer », peut avantageusement être disposée sur l'électrode externe : cette couche, en rupture d'indice, sert à améliorer le coefficient d'extraction lumineux de la structure émettrice « OLED ». Il peut s'agir par exemple d'une couche de SiOx, évaporée à travers un pochoir à la dimension de l'écran, comme l'électrode externe. La structure émettrice « OLED » est par exemple constituée d'un empilement de films organiques conçu pour transférer les électrons et les trous qui proviennent des électrodes et qui sont recombinés pour générer des excitons et donc l'émission de lumière.

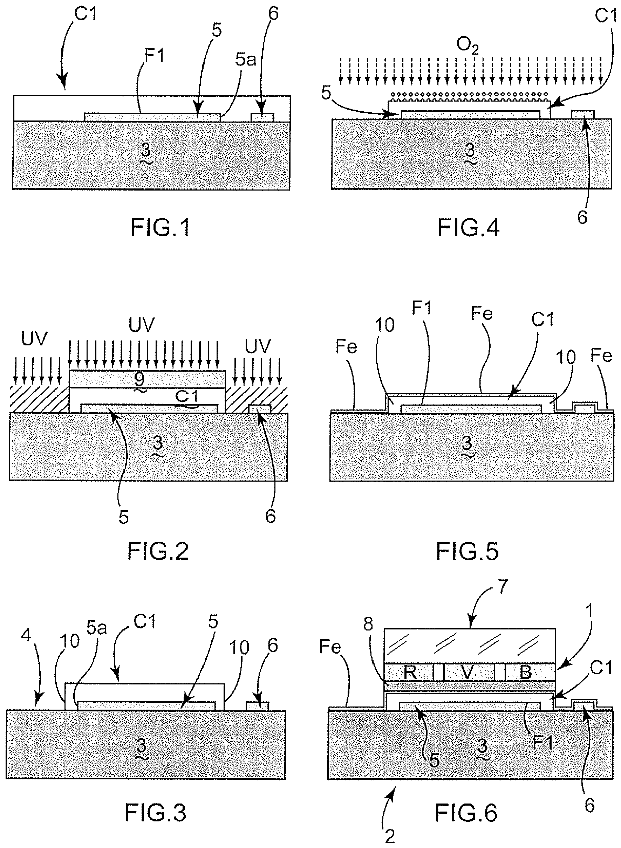

Comme notamment visible à la figure 6, une structure d'encapsulation 1 peut comprendre, selon le premier mode de l'invention :
- un film inorganique diélectrique interne F1 de « pré-encapsulation » déposé de préférence par « ALD » sur chaque zone active 5 de l'unité « OLED », qui est par exemple à base d'un oxyde Al₂O₃ avantageusement déposé à une température inférieure à 110° C afin d'éviter de détériorer la structure « OLED », typiquement à 85° C, selon une épaisseur comprise entre 10 nm et 30 nm (par exemple 25 nm) optionnellement combiné à un dépôt « PECVD » de Si₃N₄ ou SiO₂ (e.g. Al₂O₃ « ALD » / Si₃N₄ ou Al₂O₃ « ALD » / SiO₂), ou encore à base d'un empilement d'une ou plusieurs multicouches Al₂O₃/ZnO (l'ensemble de l'empilement pouvant être réalisé par « ALD »),
- une couche polymérique C1 par exemple à base d'une résine photosensible positive de dénomination « TELR-P002 » ou « JSR420 », qui recouvre de manière enveloppante chaque zone active 5 recouverte du film F1 en débordant continûment de la périphérie de ce film F1 mais à distance de la zone de connexion 6 adjacente et des autres couches polymériques C1 enveloppant les zones actives voisines 5,
- un film inorganique diélectrique externe Fe à effet de barrière qui recouvre continûment la totalité de l'unité « OLED » (zones de connexion 6 incluses) et qui est de préférence déposé par « ALD », « PECVD » ou « PVD » d'Al₂O₃ (déposé à une température inférieure à 110° C, typiquement à 85° C, selon une épaisseur comprise entre 10 nm et 30 nm et par exemple de 25 nm), de Si₃N₄, d'Al₂O₃/Si₃N₄ ou de SiO₂ par exemple, et
- un capot de protection 7 (par exemple en verre ou en matière plastique) qui est pourvu sur sa face interne de filtres optiques colorés R, V, B disposés en regard des points de couleur correspondants de chaque pixel de microécran et qui est assemblé sous pression sur celui-ci via une colle 8 (de préférence acrylate ou époxy) réticulable par un rayonnement UV.

La figure 1 illustre le « couchage » à la tournette de la couche C1 formée de la résine positive sur la totalité de l'unité « OLED » (selon une épaisseur comprise typiquement entre 300 nm et 1 µm environ), zone de connexion 6 incluse, étant précisé que la zone active 5 de microécran a été préalablement revêtue du film inorganique F1, avec optionnellement utilisation d'un promoteur d'adhésion de type HMDS (épaisseur de l'ordre du nm obtenue en étuve à 100° C pendant 30 s) préalablement à ce couchage. On peut réaliser un recuit (« bake » en anglais) de la résine à une température de recuit compatible avec les dispositifs organiques du type « OLED » qui peut être inférieure à 110° C pour les « OLED » à petites molécules et à 140° C pour les « OLED » à polymères (également appelées « PLED » pour « Polymer Light Emitting Diode »).

La figure 2 montre l'insolation de la couche C1 au-delà de la zone active 5 du microécran mais en deçà de la zone de connexion 6 adjacente comportant les plots de contact afin de la laisser libre pour la prise de contact ultérieure en unité de fabrication finale (« back-end » en anglais), grâce au masque de photolithographie 9 surmontant de manière débordante cette zone active 5 et s'opposant ainsi à la dépolymérisation de la résine engendrée par le rayonnement UV d'insolation.

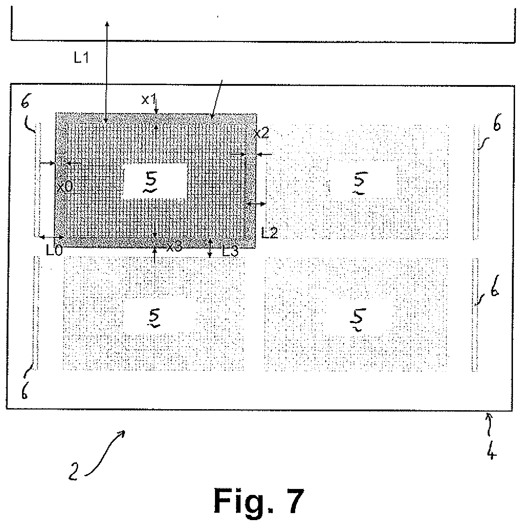

Comme illustré à la figure 7, on veille à définir une surface maximum autorisée pour chaque portion débordante structurée 10 de la couche C1 insolée qui est représentée par une distance (xi, i=0, ..., 3) entre le bord périphérique 5a de chaque zone active 5 de microécran et le bord périphérique du masque 9 (lequel définit également le bord final de cette portion 10). En effet, la distance xi joue un rôle important contre la pénétration latérale par diffusion de vapeur d'eau dans le dispositif et doit être la plus grande possible afin de retarder cette pénétration. Cette distance xi doit être également choisie en fonction de la disposition des autres microécrans contenus dans le champ concerné par le masquage (champ de « stepper » en anglais) et dans les champs mitoyens. Les différentes distances xi peuvent donc être différentes. On peut réaliser un découpage à la scie sous forme de dés (« dicing » en anglais) dans le champ même, et ce entre les quatre microécrans du champ dans l'exemple de la figure 7 avec dans ce cas les distances xi qui doivent en plus tenir compte de la largeur des traits de scie.

On peut avantageusement, dans le cas d'un design avec quatre écrans par champ, respecter les conditions dimensionnelles suivantes pour ces distances xi :
- x0 ≤ L0
- x1 < (L1)/2
- x2 < (L2)/2
- x3 < (L3)/2

La figure 3 montre le résultat de l'étape de développement (par trempage dans un bain développeur de TMAH, par exemple) de la couche C1 ainsi dissoute de manière sélective à une distance prédéterminée de la zone active 5 et conservée à l'état polymérisé de manière enveloppante sur cette dernière, de sorte à protéger les composants de cette zone active 5 du bain de développeur. Ce développement a notamment pour effet de libérer les plots de contact de la zone de connexion 6. Suite à ce développement, on peut réaliser un recuit de la couche C1 et, optionnellement, une insolation complémentaire de celle-ci en fonction de la stabilité à long terme de la résine dans un état ou dans l'autre.

Il est possible à ce stade ou après l'étape de gravure qui va être décrite juste après, de réaliser une nouvelle étape d'insolation de la résine positive sur l'ensemble de la résine résiduelle (toujours sous lampe UV par exemple à 365 nm). La dose d'insolation peut être comprise par exemple entre 60 mW et 100 mW et être ajustée en fonction de l'épaisseur de résine. On a constaté en effet qu'une telle étape pouvait améliorer la tenue dans le temps du dispositif en limitant l'apparition de cloques en surface.

La figure 4 montre une étape de gravure sèche mise en œuvre par gravure ionique réactive (« RIE ») ou avantageusement par plasma d'oxygène (O₂) de la couche C1 restante, pour diminuer son épaisseur totale et la rendre compatible avec les spécifications des microécrans. Cette étape permet, si la couche photosensible C1 choisie au départ est trop épaisse pour ces spécifications comme cela est le cas pour une épaisseur initiale égale ou supérieure à 1 µm (par exemple 1,3 µm pour la résine « JSR420 »), de ramener cette épaisseur à 0,5 µm environ via cette gravure sèche pour la génération actuelle de microécrans. On notera que le contrôle de l'épaisseur de l'encapsulation obtenu par cette gravure sèche permet également de contrôler l'absorption.

On a montré qu'il est possible avec un dépôt de résine « TELR-P002 » à la tournette avec une épaisseur comprise entre 300 nm et 400 nm, d'amincir par gravure cette couche à une épaisseur comprise entre 150 nm et 250 nm. La diminution de l'épaisseur de polymère permet également d'améliorer la tenue dans le temps du dispositif en facilitant son dégazage lors de l'étape facultative de recuit de cette résine, qui va être décrite ultérieurement. Ainsi l'ensemble barrière constitué des deux films inorganiques et de la couche polymérique intercalaire peut avoir une épaisseur totale inférieure à 400 nm voire inférieure à 300 nm ou même à 200 nm tout en restant très efficace. De telles épaisseurs permettent de minimiser la distance entre la structure émettrice et les filtres colorés, évitant ainsi un mélange d'information entre les pixels adjacents de différentes couleurs.

L'étape de gravure peut éventuellement être réalisée en deux étapes de gravure distinctes afin d'obtenir une gravure plus isotrope et donc une meilleure uniformité pour la cette couche polymérique.

A ce stade, une étape de recuit peut être envisagée pour améliorer la tenue dans le temps du dispositif en permettant le dégazage au moins partiel de la couche de polymère. La température de ce recuit doit être compatible avec la structure « OLED » comme précédemment décrit. On peut envisager par exemple un recuit à une température comprise entre 80° C et 100° C pendant une durée allant d'une minute à 24 heures, par exemple de 2 heures.

La figure 5 montre le résultat d'une étape ultérieure de dépôt conformant à basse température (de préférence par « ALD » ou « PECVD ») sur la couche C1 du film diélectrique externe Fe à effet de barrière, pour fermer de manière étanche la portion débordante 10 de la couche C1 et éviter ainsi la diffusion latérale d'eau à travers cette couche C1.

La figure 6, comme indiqué plus haut, est un exemple de conditionnement protecteur avec le capot 7 muni des filtres colorés R, V, B pour le microécran.

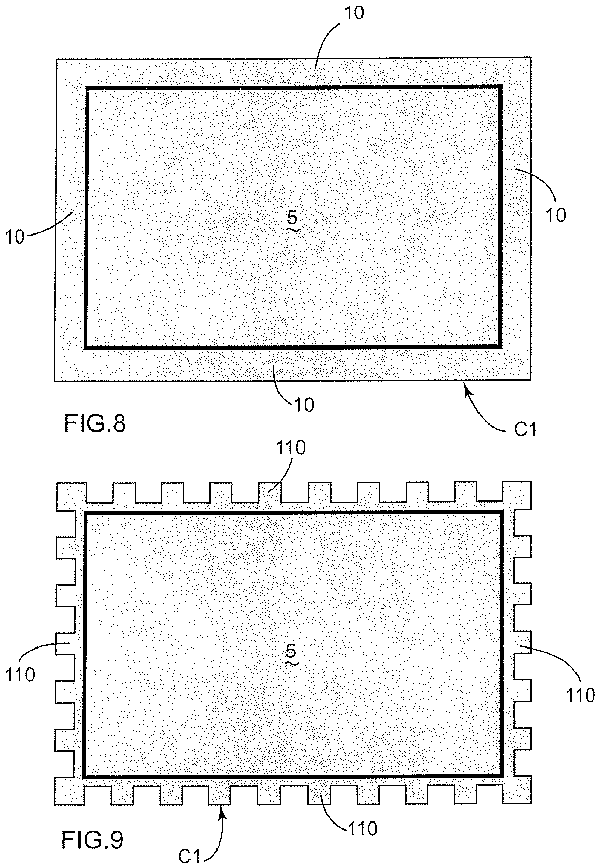

La figure 8 montre une géométrie possible pour la portion périphérique débordante 10 de la couche photosensible C1 enveloppant un microécran selon l'invention, où cette portion débordante 10 présente un contour rectangulaire de largeur constante, alors que la variante de la figure 9 montre une portion enveloppante 110 rectangulaire crénelée par exemple en forme de timbre-poste pour optimiser l'adhésion ultérieure de la colle 8 du capot 7 entre les microécrans individuels dépourvus de la couche C1 et à séparer par découpe, tout en conservant une largeur débordante suffisante pour que la couche C1 enveloppe la zone active 5 du microécran de sorte à différer suffisamment la diffusion de vapeur d'eau et à adhérer suffisamment à l'unité « OLED » 4.

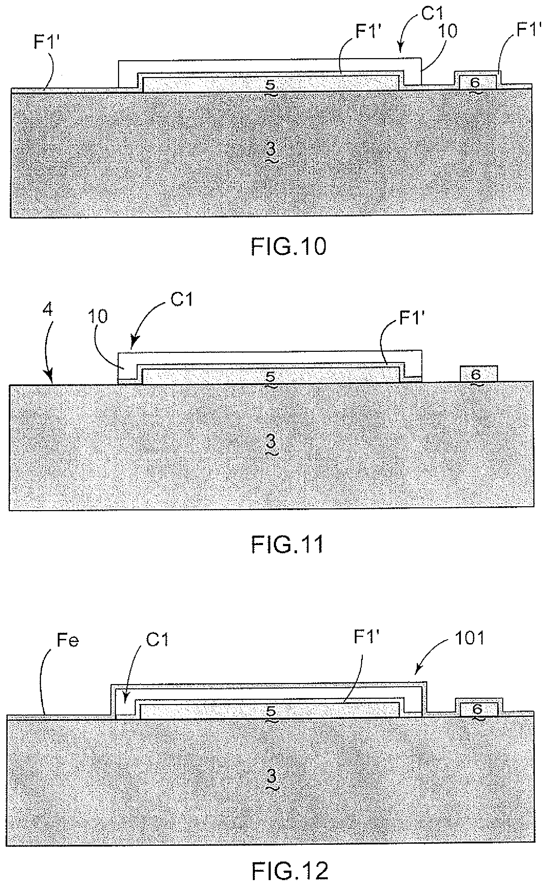

La structure d'encapsulation 101 pour microécran selon le second mode de l'invention dont la fabrication est illustrée aux figures 10 à 12 se différencie essentiellement de celle des figures 1 à 6, en ce que l'on dépose en lieu et place du film inorganique diélectrique F1 un film F1' transparent également inorganique et déposé par « ALD » mais qui est électriquement conducteur en étant de préférence constitué de ZnO ou de ZnO:Al.

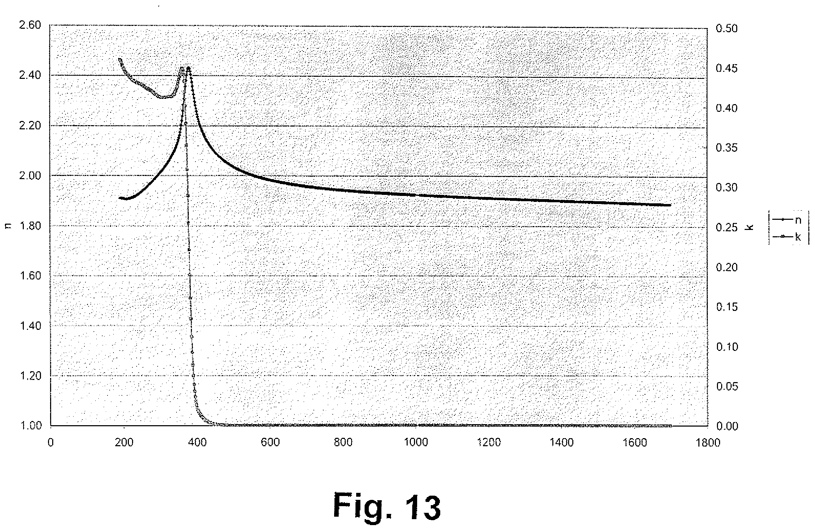

Ce film F1' à base d'un tel oxyde transparent conducteur déposé par « ALD » présente notamment les trois avantages suivants :
- il peut être déposé à une température inférieure à 100° C, ce qui convient pour ne pas altérer les composants de l'unité « OLED »,
- comme le montre le graphique de constantes optiques n et k de la figure 13 (mesures « WOOLAM » effectuées avec un appareil « Savannah 200 »), ce film F1' forme une excellente sous-couche notamment du fait que la constante n est élevée dans le domaine visible (sa valeur moyenne étant sensiblement égale à 2), et
- son dépôt par « ALD » contribue à l'obtention d'une encapsulation de qualité.

Comme visible à la figure 10, on commence par déposer ce film F1' sur toute la surface de l'unité « OLED » 4 (zone de connexion 6 incluse) avant l'enduction, l'insolation et le développement de la couche photosensible C1 qui est débordante vis-à-vis de la zone active 5 à l'instar de celle du premier mode de l'invention. On notera que ce revêtement initial du film conducteur F1' a pour effet de mettre les champs et les zones de connexion 6 en court-circuit.

Comme visible à la figure 11, on met ensuite en oeuvre une étape ultérieure de gravure humide du film F1' (par exemple avec une solution acide, par exemple à base d'HCl dilué dans de l'eau désionisée) pour sa suppression sélective au-delà de la couche polymérisée C1 (donc notamment à l'emplacement de la zone de connexion 6), cette gravure humide étant réalisée en utilisant cette couche C1 comme masque.

Et comme visible à la figure 12, on met ensuite en œuvre une étape de dépôt sur toute l'unité « OLED » 4 d'un film barrière inorganique Fe (par exemple d'Al₂O₃ déposé par « ALD ») sur cette couche C1, à l'instar du premier mode de l'invention.

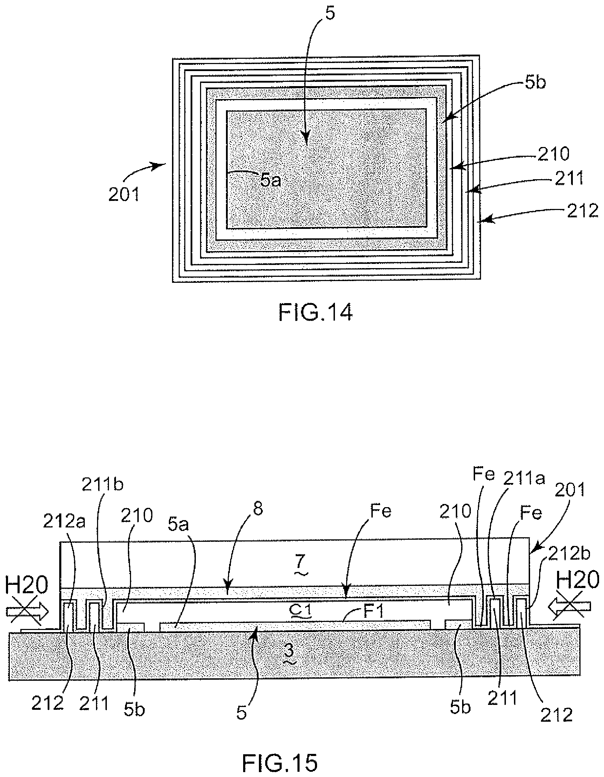

La structure d'encapsulation 201 selon la variante de l'invention illustrée aux figures 14 et 15 a sa couche photosensible C1 recouvrant la zone active 5 du microécran (laquelle zone active 5 est entourée d'un anneau de cathode 5b formant l'électrode externe et est surmontée d'un film inorganique F1 par exemple analogue à celui des figures 1 à 6) qui présente deux portions enveloppantes auxiliaires 211 et 212 espacées de manière périphérique, via un masque de photolithographie adapté, autour d'une portion enveloppante centrale 210 débordant continûment de la zone active 5. Plus précisément, on voit à la figure 15 que ces portions auxiliaires 211 et 212 forment des reliefs (de section transversale rectangulaire dans l'exemple de la figure 15) de même hauteur égale à celle de la portion centrale 210, et ces portions auxiliaires 211 et 212 sont reliées entre elles au niveau de leurs bases par le film diélectrique externe Fe à effet de barrière (par exemple à base d'Al₂O₃ déposé par « ALD », à titre non limitatif) qui revêt à la fois leurs sommets 211a, 212a et leurs flancs 211b, 212b.

Et comme visible à la figure 15 où est en outre représenté le capot transparent de protection 7 collé sur le film barrière inorganique externe Fe surmontant la couche C1, ces deux portions enveloppantes auxiliaires 211 et 212 obtenues par photolithographie permettent de minimiser encore davantage la pénétration latérale par diffusion de la vapeur d'eau extérieure, grâce à la multiplication des interfaces à effet de barrière du film externe Fe recouvrant les flancs 211b et 212b des portions auxiliaires 211 et 212 (quatre flancs dans l'exemple de la figure 15).

## Revendications

1. Dispositif optoélectronique organique (2), tel qu'un dispositif d'affichage, d'éclairage ou de signalisation à diodes électroluminescentes organiques (« OLED »), ce dispositif présentant une unité électroluminescente (4) présentant au moins une zone active (5) d'émission lumineuse revêtue d'une structure multicouches d'encapsulation (1, 101, 201) étanche et une zone de connexion électrique (6) adjacente à la ou chaque zone active, la structure d'encapsulation comprenant n empilement(s) (n ≥ 1) film inorganique F1, ..., Fn / couche polymérique photosensible C1, ..., Cn incluant un empilement interne F1/C1 où le film F1 recouvre la ou chaque zone active et est surmonté par la couche C1 qui est déposée en phase liquide, la ou chaque couche C1, ..., Cn recouvrant le film F1, ..., Fn en s'étendant autour d'un bord périphérique (5a) de la ou de chaque zone active en au moins une portion enveloppante structurée (10, 110, 210, 211, 212) se terminant en deçà de la zone de connexion adjacente, et si n ≥ 2 la ou chaque couche C2, ..., Cn étant structurée de manière enveloppante par rapport à la couche C1, ..., Cn-1 de l'empilement immédiatement sous-jacent, de telle sorte que la ou chaque couche C1, ..., Cn passive le film F1, ..., Fn et protège latéralement la ou chaque zone active sous-jacente des solvants et solutions de développement utilisés pour la gravure de cette couche C1, ..., Cn ; le ou chaque film F1, ..., Fn étant à base d'au moins un composé inorganique choisi dans le groupe constitué par les composés de formule AlₓO_{y}, SiOₓ, SiₓN_{y}, SiOₓN_{y}, ZnSe, Sb₂O₃ et les oxydes transparents conducteurs (OTC) optionnellement combinés à un métal et la ou chaque couche C1, ..., Cn étant gravée par photolithographie, **caractérisé en ce que** le ou chaque film F1, ..., Fn est déposé par dépôt de couche atomique (« ALD ») et **en ce que** la ou chaque couche C1, ..., Cn isolant la ou chaque zone active (5) est elle-même recouverte d'un film inorganique externe diélectrique (Fe) à effet de barrière qui surmonte à la fois la ou chaque zone active en recouvrant la totalité de la dernière couche C1, ..., Cn correspondante et sa zone de connexion (6) adjacente, de sorte à isoler de l'extérieur ladite au moins une portion enveloppante (10, 110, 210, 211, 212) de cette couche.

2. Dispositif (2) selon la revendication 1, **caractérisé en ce que** la ou chaque couche C1, ..., Cn est à base d'une résine positive de photolithographie.

3. Dispositif (2) selon la revendication 1, **caractérisé en ce que** le ou chaque film F1, ..., Fn est déposé par « ALD » et est à base d'au moins un oxyde d'aluminium AlₓO_{y} optionnellement combiné à un composé de formule SiOₓ, SiₓN_{y} ou SiOₓN_{y}, et **en ce que** ladite au moins une portion enveloppante (10, 110, 210, 211, 212) de la ou chaque couche C1, ..., Cn s'étend sur l'unité électroluminescente (4) au-delà de la périphérie de ce film.

4. Dispositif (2) selon la revendication 1, **caractérisé en ce que** le ou chaque film F1, ..., Fn (F1') est déposé par « ALD » et est à base d'au moins un oxyde transparent conducteur (OTC) optionnellement combiné à un métal, tel qu'un oxyde de zinc de formule ZnO ou une couche mince ZnO:Al, et **en ce que** ladite au moins une portion enveloppante (10) de la ou chaque couche C1, ..., Cn s'étend au contact de la périphérie de ce film.

5. Dispositif (2) selon une des revendications précédentes, **caractérisé en ce qu'**il est en outre pourvu d'une plaque de protection (7) qui est collée sous pression sur la structure d'encapsulation (1, 201) surmontant la ou chaque zone active (5) au moyen d'une colle (8), et **en ce que** ladite portion enveloppante (110) relative à la ou à chaque zone active présente des entailles lui conférant par exemple une forme régulièrement crénelée, de sorte à maximiser le contact entre la colle et les emplacements de l'unité électroluminescente (4) situés entre deux portions enveloppantes adjacentes sans pénaliser l'adhésion de ces dernières sur cette unité.

6. Dispositif (2) selon la revendication 4, **caractérisé en ce que** la ou chaque couche C1, ..., Cn est gravée de sorte que ladite au moins une portion enveloppante qu'elle présente comprenne une portion périphérique enveloppante débordante (210) qui déborde de manière continue au-delà dudit bord (5a) de la ou de chaque zone active (5) en enrobant cette dernière, et au moins une portion périphérique enveloppante auxiliaire (211, 212) qui entoure de manière espacée cette portion débordante et qui, dans le cas de plusieurs portions auxiliaires, s'entourent mutuellement, et **en ce que** ledit film inorganique externe diélectrique (Fe) à effet de barrière recouvre ces portions auxiliaires de sorte à former une pluralité de surfaces parallèles entre elles et perpendiculaires au plan du substrat (3) qui forment autant d'obstacles à la pénétration latérale de vapeur d'eau vers la ou chaque zone active.

7. Dispositif (2) selon une des revendications précédentes, **caractérisé en ce qu'**il comprend une multitude de zones actives (5), telles que des microécrans, qui sont toutes surmontées par les films F1, ..., Fn et par les couches C1, ..., Cn qui s'étendent chacune au-delà dudit bord sous-jacent mais à distance de ladite portion enveloppante (10, 110, 212) adjacente de chaque zone active voisine, un film inorganique externe diélectrique (Fe) surmontant optionnellement les couches ou dernières couches respectives (C1) des zones actives en recouvrant également leurs zones de connexion (6) adjacentes, et de préférence **en ce que** le dispositif forme au moins un microécran couleur qui est défini par la ou chaque zone active (5) et qui comporte des filtres colorés (R, V, B) ou des moyens changeurs de couleurs en regard de points de couleur correspondants de chaque pixel du microécran.

8. Dispositif (2) selon une des revendications précédentes comprenant un substrat (3) revêtu sur l'une au moins de ses faces de ladite unité électroluminescente (4) de type « OLED » qui comporte au moins deux électrodes interne et externe entre lesquelles est intercalée une structure émettrice de lumière et dont l'une au moins est transparente à la lumière émise, **caractérisé en ce que** la structure d'encapsulation (1, 101, 201) recouvre ladite électrode externe.

9. Dispositif (2) selon la revendication 1 de type OLED, **caractérisé en ce que** :
- il comprend une multitude de zones actives (5) d'émission lumineuse formant des microécrans,
- le film F1 est déposé par dépôt de couche atomique « ALD » combiné à un dépôt chimique en phase vapeur assisté par plasma « PECVD » de Si₃N₄ ou SiO₂, ledit film F1 étant un film de pré-encapsulation,
- la couche polymérique C1 photosensible recouvre de manière enveloppante chaque zone active (5) recouverte du film F1 en débordant continûment de la périphérie du film F1 mais à distance d'une zone de connexion (6) adjacente et d'autres couches polymériques enveloppant des zones actives (5) voisines, et
- un capot de protection (7) qui est pourvu sur sa face interne de filtres optiques colorés disposés en regard de points de couleur correspondants de chaque pixel de microécran.

10. Procédé d'encapsulation d'un dispositif (2) selon une des revendications précédentes, comprenant les étapes successives suivantes :
a) on dépose un film inorganique interne F1 sur ladite au moins une zone active (5), par exemple sur une électrode externe de l'unité électroluminescente, ce film F1 étant à base d'au moins un composé inorganique de préférence choisi dans le groupe constitué par les composés de formule AlₓO_{y}, SiOₓ, SiₓN_{y}, SiOₓN_{y}, ZnSe, Sb₂O₃ et les oxydes transparents conducteurs (OTC) optionnellement combinés à un métal,
b) on recouvre l'unité électroluminescente (4) d'une couche polymérique photosensible interne C1 déposée en phase liquide par exemple à la tournette, pour que cette dernière recouvre de manière continue le ou chaque film F1 et également la zone de connexion (6) adjacente, optionnellement en déposant au préalable sur ce film F1 un promoteur d'adhésion par exemple de type silane,
c) on insole la couche C1 à des emplacements prédéterminés de l'unité électroluminescente en la masquant sélectivement des rayonnements d'insolation pour qu'elle soit, d'une part, polymérisée suite à cette insolation au-dessus de la ou de chaque zone active recouverte du film F1 et en ladite au moins une portion enveloppante (10, 110, 210, 211, 212) à distance de celle de la ou de chaque zone active adjacente et, d'autre part, dépolymérisée sur le reste de la surface de l'unité incluant la ou chaque zone de connexion, de sorte que la couche C1 polymérisée enrobe le film F1 et la ou chaque zone active en les protégeant vis-à-vis de l'étape d),
d) on développe la couche C1 polymérisée par trempage dans un bain par exemple de type tétraméthyl ammonium hydroxyde, optionnellement suivi d'une insolation complémentaire de la couche C1, puise) on répète optionnellement ces étapes a) à d) au moins une fois en déposant au moins un autre empilement film inorganique F2, ..., Fn / couche polymérique photosensible C2, ..., Cn , avec le ou chaque film F2, ..., Fn déposé sur la couche C1, ..., Cn-1 et la ou chaque couche C2, ..., Cn polymérisée de manière enveloppante par rapport à la couche C1, ..., Cn-1,
ledit procédé étant **caractérisé en ce que**
lors de l'étape a) on dépose le film inorganique interne F1 par un dépôt de couche atomique (« ALD ») ; et **en ce que**
suite à l'étape d) on met en œuvre un dépôt conformant à basse température d'un film inorganique externe (Fe) à effet de barrière qui surmonte à la fois la ou chaque zone active (5) en recouvrant la totalité de la couche C1, ..., Cn correspondante et sa zone de connexion (6) adjacente, de sorte à isoler de l'extérieur ladite au moins une portion enveloppante (10, 110, 210, 211, 212) de cette couche, ce dépôt conformant étant de préférence réalisé par un dépôt de couche atomique (« ALD ») ou un dépôt chimique en phase vapeur assisté par plasma (« PECVD ») d'au moins un composé diélectrique.

11. Procédé selon la revendication 10, **caractérisé en ce que** l'on utilise à titre de couche C1, ..., Cn une couche à base d'une résine positive de photolithographie, et **en ce qu'**à l'étape c) l'on masque sélectivement la couche C1, ..., Cn surmontant la ou chaque zone active au moyen d'un masque (9) débordant en regard dudit bord périphérique (5a) pour que cette couche y soit protégée de l'insolation en demeurant polymérisée y compris en ladite au moins une portion enveloppante (10, 110, 210, 211, 212) correspondante, au contraire du reste de cette couche C1, ..., Cn qui est dépolymérisée par cette insolation en vue de sa dissolution.

12. Procédé selon la revendication 10 ou 11, **caractérisé en ce que** :
- l'on utilise pour le ou chaque film F1, ..., Fn à déposer à l'étape a) au moins un composé inorganique diélectrique choisi dans le groupe constitué par les composés de formule AlₓO_{y}, SiOₓ, SiₓN_{y}, SiOₓN_{y}, ZnSe et Sb₂O₃, et **en ce que** suite à l'étape d) ladite au moins une portion enveloppante (10, 110, 210, 211, 212) de la ou de chaque couche C1, ..., Cn s'étend sur l'unité électroluminescente (4) au-delà de la périphérie de ce film, ou bien
- **en ce que** l'on utilise pour le ou chaque film F1, ..., Fn (F1') à déposer à l'étape a) au moins un oxyde transparent conducteur (OTC) optionnellement combiné à un métal, tel qu'un oxyde de zinc de formule ZnO ou une couche mince ZnO:Al, et **en ce que** suite à l'étape d) on réalise une gravure humide de ce film en utilisant à titre de masque la couche C1, ..., Cn polymérisée surmontant la ou chaque zone active (5) de manière débordante, de sorte que ladite au moins une portion enveloppante (10) de cette couche s'étende au contact de la périphérie de ce film et que ce dernier soit enlevé de l'unité (4) partout ailleurs.

13. Procédé selon une des revendications 10 à 12, **caractérisé en ce que** l'on met en œuvre suite à l'étape d) une gravure sèche par exemple par gravure ionique réactive (« RIE ») ou par un plasma d'oxygène, de la ou de chaque couche C1, ..., Cn polymérisée pour réduire son épaisseur.

## Patentansprüche

1. Organische optoelektronische Vorrichtung (2), wie eine Anzeige-, Beleuchtungs- oder Signalisierungsvorrichtung mit organischen elektrolumineszierenden Dioden ("OLED"), wobei diese Vorrichtung eine elektrolumineszierende Einheit (4) aufweist, die mindestens einen aktiven lichtemittierenden Bereich (5) aufweist, der mit einer dichten mehrschichtigen Verkapselungsstruktur (1, 101, 201) und einem elektrischen Verbindungsbereich (6) ausgekleidet ist, der an den oder jeden aktiven Bereich angrenzt, wobei die Verkapselungsstruktur n Stapel (n ≥ 1 ) anorganischen Films F1, ..., Fn / lichtempfindliche Polymerschicht C1, ..., Cn, einschließlich eines inneren Stapels F1/C1 umfasst, bei dem der Film F1 den oder jeden aktiven Bereich bedeckt und von der Schicht C1 überlagert ist, die in flüssiger Phase abgeschieden wird, wobei die oder jede Schicht C1, ..., Cn den Film F1, ..., Fn bedeckt, indem sie sich um einen Umfangsrand (5a) des oder jedes aktiven Bereichs in mindestens einem strukturierten umhüllenden Abschnitt (10, 110, 210, 211, 212) erstreckt und diesseits des angrenzenden Verbindungsbereichs endet, und falls n ≥ 2, die oder jede Schicht C2, ..., Cn in Bezug auf die Schicht C1, ..., Cn-1 des unmittelbar darunterliegenden Stapels derart auf umhüllende Weise strukturiert ist, dass die oder jede Schicht C1, ..., Cn den Film F1, ..., Fn passiviert und den oder jeden darunterliegenden aktiven Bereich vor den für die Gravur dieser Schicht C1, ..., Cn verwendeten Lösungsmitteln und Entwicklungslösungen schützt; wobei der oder jeder Film F1, ..., Fn auf Basis mindestens einer anorganischen Verbindung ist, die aus der Gruppe ausgewählt ist, die aus den Verbindungen der Formel AlₓO_{y}, SiOₓ, SiₓN_{y}, SiOₓN_{y}, ZnSe, Sb₂O₃ und den transparenten elektrisch leitfähigen Oxiden (OTC), wahlweise kombiniert mit einem Metall besteht, und wobei die oder jede Schicht C1, ..., Cn durch Fotolithographie graviert ist, **dadurch gekennzeichnet, dass** der oder jeder Film F1, ... Fn durch Atomlagenabscheidung ("ALD") abgeschieden ist und dadurch, dass die oder jede Schicht C1, ..., Cn, die den oder jeden aktiven Bereich (5) isoliert, selbst von einem dielektrischen äußeren anorganischen Film (Fe) mit Barrierewirkung bedeckt ist, der gleichzeitig den oder jeden aktiven Bereich überlagert, indem er die Gesamtheit der letzten entsprechenden Schicht C1, ..., Cn und deren angrenzenden Verbindungsbereich (6) bedeckt, sodass die Außenseite des mindestens einen umhüllenden Abschnitts (10, 110, 210, 211, 212) dieser Schicht isoliert ist.

2. Vorrichtung (2) nach Anspruch 1, **dadurch gekennzeichnet, dass** die oder jede Schicht C1, ..., Cn auf Basis eines positiven Fotolithographieharzes ist.

3. Vorrichtung (2) nach Anspruch 1, **dadurch gekennzeichnet, dass** der oder jeder Film F1, ... Fn durch "ALD" abgeschieden ist und auf Basis mindestens eines Aluminiumoxids AlₓO_{y} ist, wahlweise kombiniert mit einer Verbindung der Formel SiOₓ, SiₓN_{y} oder SiOₓN_{y}, und dadurch, dass der mindestens eine umhüllende Abschnitt (10, 110, 210, 211, 212) der oder jeder Schicht C1, ..., Cn sich auf der elektrolumineszierenden Einheit (4) über den Umfang dieses Films hinaus erstreckt.

4. Vorrichtung (2) nach Anspruch 1, **dadurch gekennzeichnet, dass** der oder jeder Film F1, ... Fn (F1') durch "ALD" abgeschieden ist und auf Basis mindestens eines transparenten elektrisch leitfähigen Oxids (OTC) ist, wahlweise kombiniert mit einem Metall, wie einem Zinkoxid der Formel ZnO oder einer dünnen Schicht ZnO:Al, und dadurch, dass sich der mindestens eine umhüllende Abschnitt (10) der oder jeder Schicht C1, ..., Cn beim Kontakt mit dem Umfang dieses Films erstreckt.

5. Vorrichtung (2) nach einem der vorstehenden Ansprüche, **dadurch gekennzeichnet, dass** sie weiter mit einer Schutzplatte (7) versehen ist, die unter Druck mittels eines Klebemittels (8) auf der Verkapselungsstruktur (1, 201), die den oder jeden aktiven Bereich (5) überlagert, geklebt ist, und dadurch, dass der umhüllende Abschnitt (110) bezüglich des oder jedes aktiven Bereichs Einschnitte aufweist, die ihm beispielsweise eine regelmäßig gezackte Form verleihen, sodass der Kontakt zwischen dem Klebemittel und den Einbaustellen der elektrolumineszierende Einheit (4), die sich zwischen zwei angrenzenden umhüllenden Abschnitten befinden, maximiert wird, ohne die Haftung dieser letzteren auf dieser Einheit zu beeinträchtigen.

6. Vorrichtung (2) nach Anspruch 4, **dadurch gekennzeichnet, dass** die oder jede Schicht C1, ..., Cn so graviert ist, dass der mindestens eine umhüllende Abschnitt, den sie aufweist, einen überstehenden umhüllenden Umfangsabschnitt (210) umfasst, der auf durchgehende Weise über den Rand (5a) des oder jedes aktiven Bereichs (5) hinaus übersteht, indem er diesen letzteren ummantelt, und mindestens einen umhüllenden Hilfsumfangsabschnitt (211, 212), der diesen überstehenden Abschnitt auf beabstandete Weise umgibt und, im Falle mehrerer Hilfsabschnitte, diese sich gegenseitig umgeben, und dadurch, dass der dielektrische äußere anorganische Film (Fe) mit Barrierewirkung diese Hilfsabschnitte so bedeckt, dass eine Vielzahl von untereinander parallelen und zur Ebene des Substrats (3) senkrechten Oberflächen gebildet werden, die ebenso viele Hindernisse zum seitlichen Eindringen von Wasserdampf in den oder jeden aktiven Bereich bilden.

7. Vorrichtung (2) nach einem der vorstehenden Ansprüche, **dadurch gekennzeichnet, dass** sie eine Vielzahl von aktiven Bereichen (5), wie Mikrobildschirmen, umfasst, die alle von den Filmen F1, ..., Fn und den Schichten C1, ..., Cn überlagert sind, die sich jeweils über den darunterliegenden Rand hinaus, jedoch in einem Abstand zum angrenzenden umhüllenden Abschnitt (10, 110, 212) jedes benachbarten aktiven Bereichs erstrecken, wobei ein dielektrischer äußerer anorganischer Film (Fe) wahlweise die Schichten oder entsprechenden letzten Schichten (C1) der aktiven Bereiche überlagert, indem er ebenfalls ihre angrenzenden Verbindungsbereiche (6) bedeckt, und vorzugsweise dadurch, dass die Vorrichtung mindestens einen Farbmikrobildschirm bildet, der durch den oder jeden aktiven Bereich (5) definiert ist und Farbfilter (R, V, B) oder Mittel zum Ändern der Farben in Bezug auf entsprechende Farbpunkte jedes Pixels des Mikrobildschirms beinhaltet.

8. Vorrichtung (2) nach einem der vorstehenden Ansprüche, ein Substrat (3) umfassend, das auf mindestens einen seiner Seiten mit der elektrolumineszierenden Einheit (4) vom Typ "OLED" ausgekleidet ist, die mindestens zwei innere und äußere Elektroden beinhaltet, zwischen denen eine lichtemittierende Struktur eingefügt ist und von denen mindestens eine für emittiertes Licht transparent ist, **dadurch gekennzeichnet, dass** die Verkapselungsstruktur (1, 101, 201) die äußere Elektrode bedeckt.

9. Vorrichtung (2) nach Anspruch 1 vom Typ OLED, **dadurch gekennzeichnet, dass**:
- sie eine Vielzahl von aktiven lichtemittierenden Bereichen (5) aufweist, die Mikrobildschirme bilden,
- der Film F1 durch Atomlagenabscheidung "ALD" kombiniert mit einer chemischen Abscheidung in Dampfphase, unterstützt durch Si₃N₄₋ oder SiO₂-Plasma "PECVD", abgeschieden ist, wobei der Film F1 ein Vorverkapselungsfilm ist,
- die lichtempfindliche Polymerschicht C1 auf umhüllende Weise jeden vom Film F1 bedeckten aktiven Bereich (5) bedeckt, indem sie durchgehend vom Umfang des Films F1, jedoch in einem Abstand zu einem angrenzenden Verbindungsbereich (6) und anderen umhüllenden Polymerschichten der benachbarten aktiven Bereiche (5) übersteht, und
- eine Schutzhaube (7), die auf ihrer Innenseite mit optischen Farbfiltern versehen ist, die in Bezug auf entsprechende Farbpunkte jedes Mikrobildschirmpixels angeordnet sind.

10. Verfahren zur Verkapselung einer Vorrichtung (2) nach einem der vorstehenden Ansprüche, umfassend die folgenden aufeinanderfolgenden Schritte:
a) Abscheiden eines inneren anorganischen Films F1 auf dem mindestens einen aktiven Bereich (5), beispielsweise auf einer äußeren Elektrode der elektrolumineszierenden Einheit, wobei dieser Film F1 auf Basis mindestens einer anorganischen Verbindung ist, die vorzugsweise aus der Gruppe ausgewählt ist, die aus den Verbindungen der Formel AlₓO_{y}, SiOₓ, SiₓN_{y}, SiOₓN_{y}, ZnSe, Sb₂O₃ und den transparenten elektrisch leitfähigen Oxiden (OTC), wahlweise kombiniert mit einem Metall, besteht,
b) Bedecken der elektrolumineszierenden Einheit (4) mit einer inneren lichtempfindlichen Polymerschicht C1, die in flüssiger Phase, beispielsweise durch Drehbeschichtung abgeschieden ist, damit diese letztere den oder jeden Film F1 und ebenfalls den angrenzenden Verbindungsbereich (6) auf durchgehende Weise, wahlweise durch vorheriges Abscheiden eines Haftverstärkers, beispielsweise vom Silantyp, auf diesen Film F1, bedeckt,
c) Insolieren der Schicht C1 an vorbestimmten Stellen der elektrolumineszierenden Einheit, indem sie selektiv vor Insolationsstrahlen abgeschirmt wird, damit sie einerseits nach dieser Insolation oberhalb des oder jedes aktiven Bereichs, der mit dem Film F1 bedeckt ist, und im mindestens einen umhüllenden Abschnitt (10, 110, 210, 211, 212) in einem Abstand zu jenem des oder jeden angrenzenden aktiven Bereichs polymerisiert wird, andererseits auf dem Rest der Oberfläche der Einheit, einschließlich des oder jedes Verbindungsbereichs, depolymerisiert wird, sodass die polymerisierte Schicht C1 den Film F1 und den oder jeden aktiven Bereich umkleidet, indem sie diese gegenüber Schritt d) schützt,
d) Entwickeln der polymerisierten Schicht C1 durch Tauchen in ein Bad, beispielsweise vom Typ Tetramethylammoniumhydroxid, wahlweise gefolgt von einer ergänzenden Insolation der Schicht C1, dann
e) wahlweise Wiederholen dieser Schritte a) bis d) mindestens einmal, indem mindestens ein weiterer Stapel eines anorganischen Films F2, ..., Fn / einer lichtempfindlichen Polymerschicht C2, ..., Cn abgeschieden wird, mit dem oder jedem Film F2, ..., Fn auf der Schicht C1, ..., Cn-1 und der oder jeder polymerisierten Schicht C2, ..., Cn auf umhüllende Weise in Bezug auf die Schicht C1, ... Cn-1 abgeschieden,
wobei das Verfahren **dadurch gekennzeichnet ist, dass**
beim Schritt a) der innere anorganische Film F1 durch Atomlagenabscheidung ("ALD") abgeschieden wird; und dadurch, dass
nach dem Schritt d) eine sich anpassende Niedertemperaturabscheidung eines äußeren anorganischen Films (Fe) mit Barrierewirkung eingesetzt wird, die gleichzeitig den oder jeden aktiven Bereich (5) überlagert, indem sie die Gesamtheit der entsprechenden Schicht C1, ..., Cn und ihren angrenzenden Verbindungsbereich (6) bedeckt, sodass die Außenseite des mindestens einen umhüllenden Abschnitts (10, 110, 210, 211, 212) dieser Schicht isoliert wird, wobei diese sich anpassende Abscheidung vorzugsweise durch eine Atomlagenabscheidung ("ALD") oder eine chemische Abscheidung in Dampfphase, unterstützt durch Plasma ("PECVD") mindestens einer dielektrischen Verbindung, umgesetzt wird.

11. Verfahren nach Anspruch 10, **dadurch gekennzeichnet, dass** eine Schicht auf Basis eines positiven Fotolithographieharzes als Schicht C1, ..., Cn verwendet wird, und dadurch, dass im Schritt c) die Schicht C1, ..., Cn, die den oder jeden aktiven Bereich überlagert, mit Hilfe einer Abschirmung (9), die in Bezug auf den Umfangsrand (5a) übersteht, selektiv abgeschirmt wird, damit diese Schicht dort vor der Insolation geschützt ist, indem sie, im mindestens einen entsprechenden umhüllenden Abschnitt (10, 110, 210, 211, 212) inbegriffen, im Gegensatz zum Rest dieser Schicht C1, ..., Cn, der durch diese Insolation angesichts seiner Auflösung depolymerisiert wird, polymerisiert bleibt.

12. Verfahren nach Anspruch 10 oder 11, **dadurch gekennzeichnet, dass**:
- für den oder jeden im Schritt a) abzuscheidenden Film F1, ..., Fn mindestens eine dielektrische anorganische Verbindung verwendet wird, die aus der Gruppe ausgewählt wird, die aus den Verbindungen der Formel AlₓO_{y}, SiOₓ, SiₓN_{y}, SiOₓN_{y}, ZnSe, Sb₂O₃ besteht, und dadurch, dass nach dem Schritt d) der mindestens eine umhüllende Abschnitt (10, 110, 210, 211, 212) der oder jeder Schicht C1, ..., Cn sich auf der elektrolumineszierenden Einheit (4) über den Umfang dieses Films hinaus erstreckt, oder aber
- dadurch, dass für den oder jeden im Schritt a) abzuscheidenden Film F1, ..., Fn(F1') mindestens ein transparentes elektrisch leitfähiges Oxid (OTC), wahlweise kombiniert mit einem Metall, wie einem Zinkoxid der Formel ZnO oder einer dünnen Schicht ZnO:AI verwendet wird, und dadurch, dass nach dem Schritt d) eine Feuchtgravur dieses Films umgesetzt wird, indem die polymerisierte Schicht C1, ..., Cn, die den oder jeden aktiven Bereich (5) auf überstehende Weise überlagert, als Abschirmung verwendet wird, sodass der mindestens eine umhüllende Abschnitt (10) dieser Schicht sich beim Kontakt mit dem Umfang dieses Films erstreckt und dass dieser letztere an allen anderen Stellen von der Einheit (4) entfernt wird.

13. Verfahren nach einem der Ansprüche 10 bis 12, **dadurch gekennzeichnet, dass** nach dem Schritt d) eine Trockengravur, beispielsweise durch reaktive ionische Gravur ("RIE") oder durch ein Sauerstoffplasma, der oder jeder polymerisierten Schicht C1, ... Cn eingesetzt wird, um deren Dicke zu verringern.

## Claims

1. Organic optoelectronic device (2), such as a display, lighting or signalling device with organic light-emitting diodes ("OLED"), the device having a light-emitting unit (4) having at least one active zone (5) for light emission coated with a sealed multi-layer encapsulation structure (1, 101, 201) and an electrical connection zone (6) adjacent to the or each active zone, the encapsulation structure comprising n stack(s) (n ≥ 1) inorganic film F1, ..., Fn / photosensitive polymeric layer C1, ..., Cn including an internal stack F1/C1 where the film F1 covers the or each active zone and is superposed by the layer C1 which is deposited in a liquid phase, the or each layer C1, ..., Cn covering the film F1, ..., Fn by extending around a peripheral edge (5a) of the or of each active zone in at least one structured surrounding portion (10, 110, 210, 211, 212) ending beyond the adjacent connection zone, and if n ≥ 2 the or each layer C2, ..., Cn being structured in a surrounding manner with respect to the layer C1, ..., Cn-1 of the immediately underlying stack, such that the or each layer C1, ..., Cn passivates the film F1, ..., Fn and laterally protects the or each underlying active zone from the developing solutions and solvents used for etching this layer C1, ..., Cn; the or each film F1, ..., Fn having a base of at least one inorganic compound selected from the group comprising compounds having formula AlₓO_{y}, SiOₓ, SiₓN_{y}, SiOₓN_{y}, ZnSe, Sb₂O₃ and transparent conductive oxides (TCOs) optionally combined with a metal and the or each layer C1, ..., Cn being etched by photolithography, **characterised in that** the or each film F1, ..., Fn is deposited by atomic layer deposition ("ALD") and **in that** the or each layer C1, ..., Cn insulating the or each active zone (5) is itself coated by an external inorganic dielectric barrier film (Fe) which superposes both the or each active zone by covering the entire corresponding last layer C1, ..., Cn and the adjacent connection zone (6) thereof, so as to insulate from the outside said at least one surrounding portion (10, 110, 210, 211, 212) of this layer.

2. Device (2) according to claim 1, **characterised in that** the or each layer C1, ..., Cn has a base of a positive photolithography resin.

3. Device (2) according to claim 1, **characterised in that** the or each film F1, ..., Fn is deposited by "ALD" and has a base of at least one aluminium oxide AlₓO_{y} optionally combined with a compound having formula SiOₓ, SiₓN_{y} or SiOₓN_{y}, and **in that** said at least one surrounding portion (10, 110, 210, 211, 212) of the or each layer C1, ..., Cn extends over the light-emitting unit (4) beyond the periphery of this film.

4. Device (2) according to claim 1, **characterised in that** the or each film F1, ..., Fn (F1') is deposited by "ALD" and has a base of at least one transparent conductive oxide (TCO) optionally combined with a metal, such as a zinc oxide having formula ZnO or a thin layer ZnO:AI, and **in that** said at least one surrounding portion (10) of the or each layer C1, ..., Cn extends in contact with the periphery of this film.

5. Device (2) according to one of the preceding claims, **characterised in that** a protective plate (7) is further provided which is glued under pressure on the encapsulation structure (1, 201) superposed on the or each active zone (5) by means of a glue (8), and **in that** said surrounding portion (110) with respect to the or to each active zone has notches which provides it for example, with a regularly crenulated shape, so as to maximise the contact between the glue and the locations of the light-emitting unit (4) located between two adjacent surrounding portions without penalising the adhesion of the latter on this unit.

6. Device (2) according to claim 4, **characterised in that** the or each layer C1, ..., Cn is etched such that said at least one of the surrounding portions thereof comprises an overhanging surrounding peripheral portion (210) that overhangs continuously beyond said edge (5a) of the or each active zone (5) by coating the latter, and at least one auxiliary surrounding peripheral portion (211, 212) that surrounds in a spaced manner this overhanging portion and which, in the case of several auxiliary portions, are mutually surrounded, and **in that** said external inorganic dielectric barrier film (Fe) covers these auxiliary portions so as to form a plurality of surfaces parallel to each other and perpendicular to the plane of the substrate (3) which form as many obstacles to the lateral penetration of steam towards the or each active zone.

7. Device (2) according to one of the preceding claims, **characterised in that** it comprises a multitude of active zones (5), such as microdisplay, which are all superposed by the films F1, ..., Fn and by the layers C1, ..., Cn which each extend beyond said underlying edge but at a distance from said adjacent surrounding portion (10, 110, 212) of each neighbouring active zone, an external inorganic dielectric film (Fe) optionally superposed on the layers or last respective layers (C1) of the active zones by also covering their adjacent connection zones (6), and preferably **in that** the device forms at least one colour microdisplay that is defined by the or each active zone (5) and which comprises coloured filters (R, V, B) or means for changing colours with regards to the corresponding colour points of each pixel of the microdisplay.

8. Device (2) according to one of the preceding claims comprising a substrate (3) coated on at least one of the sides thereof with said light-emitting unit (4) of the "OLED" type that includes at least two internal and external electrodes between which is inserted a light-emitting structure and of which at least one is transparent to the light emitted, **characterised in that** the encapsulation structure (1, 101, 201) covers said external electrode.

9. Device (2) according to claim 1 of the OLED type, **characterised in that**:
- it comprises a multitude of active zones (5) for emitting light forming microscreens,
- the film F1 is deposited by atomic layer deposition "ALD" combined with a plasma enhanced chemical vapour deposition, "PECVD" of Si₃N₄ or SiO₂, said film F1 being a pre-encapsulation film,
- the photosensitive polymeric layer C1 covers in a surrounding manner each active zone (5) coated with the film F1 by continuously overhanging the periphery of the film F1 but at a distance from an adjacent connection zone (6) and from other polymeric layers that surround neighbouring active zones (5), and
- a protective cover (7) that is provided on the internal face thereof with coloured optical filters disposed facing corresponding colour points of each microscreen pixel.

10. Method for encapsulating a device (2) according to one of the preceding claims, comprising the following successive steps:
a) an internal inorganic film F1 is deposited onto said at least one active zone (5), for example on an external electrode of the light-emitting unit, with this film F1 having a base of at least one inorganic compound preferably chosen from the group comprising compounds having formula AlₓO_{y}, SiOₓ, SiₓN_{y}, SiOₓN_{y}, ZnSe, Sb₂O₃ and transparent conductive oxides (TCOs) optionally combined with a metal,
b) the light-emitting unit (4) is covered with an internal photosensitive polymeric layer C1 deposited in a liquid phase for example, by spin-coating, such that the latter continuously covers the or each film F1 and also the adjacent connection zone (6), optionally by depositing beforehand on this film F1 an adhesion promoter for example, of the silane type,
c) the layer C1 is protected at predetermined locations of the light-emitting unit by selectively masking it from the exposure radiation such that it is, on the one hand, polymerised following this exposure above the or each active zone coated with the film F1 and in said at least one surrounding portion (10, 110, 210, 211, 212) at a distance from that of the or each adjacent active zone and, on the other hand, depolymerised on the remainder of the surface of the unit including the or each connection zone, such that the polymerised layer C1 coats the film F1 and the or each active zone by protecting them with regards to step d),
d) the polymerised layer C1 is developed by soaking in a bath for example, of the tetramethyl ammonium hydroxide type, optionally followed by an additional exposure of the layer C1, then these steps a) to d) are optionally repeated at least once by depositing at least one other stack inorganic film F2, ..., Fn / photosensitive polymeric layer C2, ..., Cn , with the or each film F2, ..., Fn deposited on the layer C1, ..., Cn-1 and the or each polymerised layer C2, ..., Cn in a surrounding manner with respect to the layer C1, ..., Cn-1,
said method being **characterised in that**
during step a), the internal inorganic film F1 is deposited by atomic layer deposition ("ALD"); and **in that**
following step d), a low-temperature conforming deposition of an external inorganic barrier film (Fe) is implemented, which superposes both the or each active zone (5) by covering the entire corresponding layer C1, ..., Cn and the adjacent connection zone (6) thereof, so as to insulate from the outside said at least one surrounding portion (10, 110, 210, 211, 212) of this layer, this conformal deposition being preferably carried out by an atomic layer deposition ("ALD") or a plasma enhanced chemical vapour deposition ("PECVD") of at least one dielectric compound.

11. Method according to claim 10, **characterised in that** use is made of a layer with a positive photolithography resin as a layer C1, ..., Cn, and **in that** in step c), the layer C1, ..., Cn superposing the or each active zone is selectively masked by means of an overhanging mask (9) with regards to said peripheral edge (5a) such that this layer is protected thereby from exposure and remains polymerised including in said at least one surrounding corresponding portion (10, 110, 210, 211, 212), in contrast to the remainder of this layer C1, ..., Cn that is depolymerised by this exposure with a view to dissolving it.

12. Method according to claim 10 or 11, **characterised in that**:
- for the or each film F1, ..., Fn to be deposited in step a), at least one inorganic dielectric compound is used, selected from the group comprising compounds having formula AlₓO_{y}, SiOₓ, SiₓN_{y}, SiOₓN_{y}, ZnSe and Sb₂O₃, and **in that** following step d), said at least one surrounding portion (10, 110, 210, 211, 212) of the or each layer C1, ..., Cn extends over the light-emitting unit (4) beyond the periphery of this film, or
- **in that** for the or each film F1, ..., Fn (F1') to be deposited in step a), at least one transparent conductive oxide (TCO) is used optionally combined with a metal, such as a zinc oxide having formula ZnO or a thin layer ZnO:AI, and **in that** following step d), a wet etching is carried out of this film by using as a mask the polymerised layer C1, ..., Cn superposing the or each active zone (5) in an overhanging manner, such that said at least one surrounding portion (10) of this layer extends in contact with the periphery of this film and that the latter is removed from the unit (4) everywhere else.

13. Method according to one of claims 10 to 12, **characterised in that** following step d), a dry etching is implemented for example, by reactive ionic etching ("RIE") or by an oxygen plasma, of the or each polymerised layer C1, ..., Cn to reduce the thickness thereof.
